# EUROPEAN PATENT APPLICATION

(11) **EP 4 472 392 A1**
(43) Date of publication of application: **04.12.2024**
(21) Application number: 23759486.6
(22) Date of filing: 05.01.2023
(51) Int. Cl.: H10N 10/856, H10N 10/01, H10N 10/855

(54) **N-TYPE MATERIAL FOR THERMOELECTRIC CONVERSION, METHOD FOR PRODUCING SAME, DOPANT, AND THERMOELECTRIC CONVERSION ELEMENT**

(30) Priority: 25.02.2022 JP 2022027725
(71) Applicant: Denka Company Limited, Tokyo 103-8338 (JP)
(72) Inventor: NIWA, Ryota, Tokyo 103-8338 (JP); ASAMI, Takeshi, Tokyo 103-8338 (JP); MAEDA, Ryota, Tokyo 103-8338 (JP)
(74) Representative: Müller-Boré & Partner Patentanwälte PartG mbB
(86) International application number: PCT/JP2023/000062
(87) International publication number: WO 2023/162480

(57) **Abstract**

An n-type material for thermoelectric conversion obtained by doping a p-type material for thermoelectric conversion with a dopant, the p-type material for thermoelectric conversion containing a carbon nanotube and a conductive resin, in which the dopant contains a complex ion containing a divalent iron ion, an alkali metal cation, a cation scavenger, and a reducing agent.

## Description

### Technical Field

The present invention relates to an n-type material for thermoelectric conversion, a method for producing the same, a dopant, and a thermoelectric conversion element.

### Background Art

Thermoelectric conversion is a technique for directly converting heat into electricity by utilizing a Seebeck effect and draws attention as an energy recovery technique for converting waste heat or the like generated when fossil fuel is used into electricity.

A thermoelectric conversion element used in the above-described field is preferably a bipolar element which includes both a material exhibiting p-type conductivity and a material exhibiting n-type conductivity, but nanomaterials often exhibit p-type conductivity. Therefore, there is a demand for a technique for converting a nanomaterial exhibiting p-type conductivity into a nanomaterial exhibiting n-type conductivity.

For example, Patent Literature 1 discloses an n-type dopant for converting a nanomaterial exhibiting p-type conductivity into a nanomaterial exhibiting n-type conductivity.

Note that, whether a nanomaterial exhibits p-type conductivity or n-type conductivity can be determined depending on whether a Seebeck coefficient is positive or negative (when the Seebeck coefficient is positive, the nanomaterial exhibits p-type conductivity, and when the Seebeck coefficient is negative, the nanomaterial exhibits n-type conductivity).

### Citation List

### Patent Literature

Patent Literature 1: International Publication WO 2015/198980

### Summary of Invention

### Technical Problem

An object of the present invention is to provide a novel dopant capable of efficiently converting a p-type material for thermoelectric conversion into an n-type material for thermoelectric conversion. Furthermore, another object of the present invention is to provide an n-type material for thermoelectric conversion obtained by doping a p-type material for thermoelectric conversion with the dopant. Further, still another object of the present invention is to provide a method for the n-type material for thermoelectric conversion and a thermoelectric conversion element containing the n-type material for thermoelectric conversion.

### Solution to Problem

The present invention relates to, for example, the following [1] to [11].
[1] An n-type material for thermoelectric conversion obtained by doping a p-type material for thermoelectric conversion with a dopant, the p-type material for thermoelectric conversion containing a carbon nanotube and a conductive resin, in which
   the dopant contains a complex ion containing a divalent iron ion, an alkali metal cation, a cation scavenger, and a reducing agent.
[2] The n-type material for thermoelectric conversion described in [1], in which the cation scavenger is a crown ether-based compound.
[3] The n-type material for thermoelectric conversion described in [2], in which the cation scavenger is a crown ether-based compound having a benzene ring in the molecule.
[4] The n-type material for thermoelectric conversion described in any one of [1] to [3], in which the conductive resin is configured by poly(3,4-ethylenedioxythiophene) and an electron acceptor.
[5] The n-type material for thermoelectric conversion described in any one of [1] to [4], in which the reducing agent includes at least one selected from the group consisting of ascorbic acid and a salt thereof, a reducing sugar, oxalic acid and a salt thereof, formic acid, an alkali metal iodide, and tin (II) chloride.
[6] A dopant doped in a p-type material for thermoelectric conversion and used for n-type conversion of the p-type material for thermoelectric conversion, the p-type material for thermoelectric conversion containing a carbon nanotube and a conductive resin, the dopant containing:
   an anion that is a complex ion; an alkali metal cation; a cation scavenger; and a reducing agent.
[7] A method for producing an n-type material for thermoelectric conversion, the method including a step of doping a p-type material for thermoelectric conversion with a dopant, the p-type material for thermoelectric conversion containing a carbon nanotube and a conductive resin, in which
   the dopant contains an anion that is a complex ion, an alkali metal cation, a cation scavenger, and a reducing agent.
[8] The method for producing an n-type material for thermoelectric conversion described in [7], in which the step includes:
   an impregnation step of impregnating at least a part of the p-type material for thermoelectric conversion with a dopant solution containing the dopant and a solvent; and
   a solvent removal step of removing the solvent.
[9] The method for producing an n-type material for thermoelectric conversion described in [7], in which the step includes:
   an impregnation step of impregnating a part of a resin layer containing the p-type material for thermoelectric conversion with a dopant solution containing the dopant and a solvent; and
   a solvent removal step of removing the solvent to obtain a thermoelectric conversion layer containing the p-type material for thermoelectric conversion and an n-type material for thermoelectric conversion.
[10] A thermoelectric conversion element containing the n-type material for thermoelectric conversion described in any one of [1] to [5].
[11] The thermoelectric conversion element described in [10], further containing the p-type material for thermoelectric conversion.

### Advantageous Effects of Invention

According to the present invention, there is provided a novel dopant capable of efficiently converting a p-type material for thermoelectric conversion into an n-type material for thermoelectric conversion. Furthermore, according to the present invention, there is provided an n-type material for thermoelectric conversion obtained by doping a p-type material for thermoelectric conversion with the dopant. Further, according to the present invention, there are provided a method for the n-type material for thermoelectric conversion and a thermoelectric conversion element containing the n-type material for thermoelectric conversion.

### Description of Embodiments

Hereinafter, preferred embodiments of the present invention will be specifically described.

### <N-type material for thermoelectric conversion>

An n-type material for thermoelectric conversion of the present embodiment is obtained by doping a p-type material for thermoelectric conversion with a dopant.

### (P-type material for thermoelectric conversion)

The p-type material for thermoelectric conversion contains a carbon nanotube and a conductive resin.

The carbon nanotube may be any of a single-layer carbon nanotube, a two-layer carbon nanotube, and a multi-layer carbon nanotube, but is preferably a single-layer carbon nanotube from the viewpoint of further improving the electric conductivity of a thermoelectric conversion material (the p-type material for thermoelectric conversion and the n-type material for thermoelectric conversion described below).

The carbon nanotube preferably includes a single-layer carbon nanotube. The content ratio of the single-layer carbon nanotube with respect to the total amount of the carbon nanotube is, for example, preferably 25% by mass or more and more preferably 50% by mass or more, and may be 100% by mass.

The diameter of the single-layer carbon nanotube is not particularly limited, and may be, for example, 20 nm or less and is preferably 10 nm or less and more preferably 3 nm or less. Note that, the lower limit of the diameter of the single-layer carbon nanotube is not particularly limited, and may be, for example, 0.4 nm or more and may be 0.5 nm or more. That is, the diameter of the single-layer carbon nanotube may be, for example, 0.4 to 20 nm, 0.4 to 10 nm, 0.4 to 3 nm, 0.5 to 20 nm, 0.5 to 10 nm, or 0.5 to 3 nm.

In the present specification, the diameter of the single-layer carbon nanotube can be determined by formula: Diameter (nm) = 248/ω from the wave number (ω (cm⁻¹)) of a peak appearing at 100 to 300 cm⁻¹ by Raman spectroscopy.

As a method for evaluating the single-layer carbon nanotube, a G/D ratio by laser Raman spectroscopy is known. In the present embodiment, the G/D ratio of the single-layer carbon nanotube in laser Raman spectroscopy at a wavelength of 532 nm is preferably 10 or more and more preferably 20 or more. By using such a single-layer carbon nanotube, there is a tendency that a thermoelectric conversion material having further excellent electric conductivity is obtained. Note that, the upper limit of the G/D ratio is not particularly limited, and may be, for example, 500 or less and may be 300 or less. That is, the G/D ratio may be, for example, 10 to 500, 10 to 300, 20 to 500, or 20 to 300.

The content of the carbon nanotube may be, for example, 20% by mass or more, and is preferably 30% by mass or more and more preferably 40% by mass or more, based on the total mass of solid contents of the p-type material for thermoelectric conversion.

Furthermore, the content of the carbon nanotube may be, for example, 99% by mass or less, and is preferably 95% by mass or less and more preferably 90% by mass or less, based on the total mass of solid contents of the p-type material for thermoelectric conversion. That is, the content of the carbon nanotube may be, for example, 20 to 99% by mass, 20 to 95% by mass, 20 to 90% by mass, 30 to 99% by mass, 30 to 95% by mass, 30 to 90% by mass, 40 to 99% by mass, 40 to 95% by mass, or 40 to 90% by mass, based on the total mass of solid contents of the p-type material for thermoelectric conversion.

The conductive resin of the present embodiment is not particularly limited, and a known conductive resin that is used for the p-type material for thermoelectric conversion can be used without particular limitation. Examples of the conductive resin include those including a polyaniline-based conductive polymer, a polythiophene-based conductive polymer, a polypyrrole-based conductive polymer, a polyacetylene-based conductive polymer, a polyphenylene-based conductive polymer, a polyphenylenevinylene-based conductive polymer, and the like. As the polythiophene-based conductive polymer, poly(3,4-ethylenedioxythiophene) can be exemplified.

As the conductive resin of the present embodiment, a conductive resin, which is configured by poly(3,4-ethylenedioxythiophene) (hereinafter, referred to as PEDOT in some cases) and an electron acceptor, is preferred. When the conductive resin of the present embodiment is such a conductive resin, there is a tendency that the electric conductivity of a thermoelectric conversion material is further enhanced.

Examples of the electron acceptor include polystyrene sulfonic acid, polyvinyl sulfonic acid, poly(meth)acrylic acid, polyvinyl sulfonic acid, toluenesulfonic acid, dodecylbenzenesulfonic acid, camphorsulfonic acid, bis(2-ethylhexyl) sulfosuccinate, chlorine, bromine, iodine, phosphorus pentafluoride, arsenic pentafluoride, boron trifluoride, hydrogen chloride, sulfuric acid, nitric acid, tetrafluoroboric acid, perchloric acid, iron(III) chloride, tetracyanoquinodimethane, and the like. From the viewpoint of further improving the electric conductivity of a thermoelectric conversion material, as the electron acceptor, polystyrene sulfonic acid (hereinafter, referred to as PSS in some cases) is preferred.

### (Dopant)

In the present specification, the dopant means a substance which changes a Seebeck coefficient of a material to be doped with the dopant.

In the present specification, the expression "changing a Seebeck coefficient" means decreasing a Seebeck coefficient value or changing a Seebeck coefficient value from a positive value to a negative value. A thermoelectric conversion material having a positive Seebeck coefficient value has p-type conductivity, and a thermoelectric conversion material having a negative Seebeck coefficient value has n-type conductivity. The Seebeck coefficient can be measured, for example, by a measurement method in Examples described below, and the polarity of a thermoelectric conversion material can be determined on whether the measured value is positive or negative.

The dopant of the present embodiment contains a complex ion containing a divalent iron ion (hereinafter, also simply referred to as "anion"), an alkali metal cation (hereinafter, also simply referred to as "cation"), a cation scavenger (hereinafter, also simply referred to as "scavenger"), and a reducing agent. By doping a p-type material for thermoelectric conversion with the dopant of the present embodiment, the Seebeck coefficient of the material can be changed to obtain an n-type material for thermoelectric conversion. Furthermore, according to the dopant of the present embodiment, an n-type material for thermoelectric conversion excellent in durability in a high-temperature and high-humidity environment (for example, 85°C/85 RH%).

The reason why the above-described effect is exhibited is not particularly limited, and is conceivable that the scavenger contained in the dopant captures the cation to dissociate the anion (complex ion) and the anion changes a carrier of the carbon nanotube from a hole to an electron. At this time, in the present embodiment, since the anion is a complex ion having a metal atom at the center, it is conceivable that the n-type conversion is significantly performed by an interaction between the metal atom and the carbon nanotube. Furthermore, it is also conceivable to exhibit the above-described effect because the ionic size of the complex ion is large so that the dissociability of the complex ion from the cation captured by the scavenger is favorable.

Furthermore, in the present embodiment, since the reducing agent is contained in the dopant, even when the amounts of the anion (complex ion) and the cation scavenger in the dopant are small, a p-type material for thermoelectric conversion can be efficiently converted into an n-type material for thermoelectric conversion. That is, in the present embodiment, while the used amounts of the anion and the cation scavenger, which are expensive, are reduced, a p-type material for thermoelectric conversion can also be efficiently converted into an n-type material for thermoelectric conversion.

The reason why the above-described effect is exhibited is not particularly limited, and is conceivable that when the iron ion oxidized at the time of changing a carrier of the carbon nanotube from a hole to an electron is reduced by the reducing agent, the carrier of the carbon nanotube can be changed again from a hole to an electron.

Note that, in the present embodiment, when the amounts of the anion (complex ion) and the reducing agent doped in the p-type material for thermoelectric conversion are large, there is a tendency that an n-type material for thermoelectric conversion more excellent in durability in a high-temperature environment (for example, 85°C/85 RH%) is easily obtained. That is, in a case where higher durability in a high-temperature environment is required, it is sufficient to increase the amounts of the anion (complex ion) and the reducing agent doped in the p-type material for thermoelectric conversion, and in a case where an n-type material for thermoelectric conversion is desired to be obtained at lower cost, the amount of the anion (complex ion) doped in the p-type material for thermoelectric conversion may be reduced.

The anion may be, for example, an anion selected from the group consisting of a ferrocyanide ion and tetrachloroferrate(II) ion. From the viewpoint of easily obtaining an n-type material for thermoelectric conversion having more favorable properties, the anion is preferably a ferrocyanide ion.

The anion may be an anion generated by disassociation of a complex salt in a dopant solution. Examples of the complex salt include potassium ferrocyanide, sodium ferrocyanide, potassium tetrachloroferrate(II), sodium tetrachloroferrate(II), and the like.

Examples of the alkali metal cation include a sodium ion, a potassium ion, a lithium ion, and the like.

The cation scavenger is not particularly limited as long as it is a substance which is capable of taking in a cation. Examples thereof include a crown ether-based compound, cyclodextrin, calixarene, ethylenediaminetetraacetate, porphyrin, phthalocyanine, derivatives thereof, and the like. In an organic solvent, a crown ether-based compound is preferably used.

Examples of the crown ether-based compound include 15-crown-5-ether, 18-crown-6-ether, 12-crown-4-ether, benzo-18-crown-6-ether, benzo-15-crown-5-ether, benzo-12-crown-4-ether, and the like. In the crown ether to be used as a scavenger, the ring size may be selected in accordance with a size of a metal ion to be taken in. For example, in a case where the metal ion is a potassium ion, an 18-membered crown ether is preferred; in a case where the metal ion is a sodium ion, a 15-membered crown ether is preferred; and in a case where the metal ion is a lithium ion, a 12-membered crown ether is preferred.

The crown ether-based compound preferably has a benzene ring in the molecule. By using such a crown ether-based compound, there are tendencies that the p-type conversion by oxidation is suppressed and the storage stability is further improved. Examples of the crown ether-based compound having a benzene ring include benzo-18-crown-6-ether, benzo-15-crown-5-ether, benzo-12-crown-4-ether, and the like.

A molar ratio (C₂/C₁) of a content C₂ of the scavenger with respect to a content C₁ of the cation may be, for example, 0.1 or more, and is preferably 0.3 or more and more preferably 0.5 or more. Furthermore, the molar ratio (C₂/C₁) of the content C₂ of the scavenger with respect to the content C₁ of the cation may be, for example, 5 or less, and is preferably 3 or less and more preferably 2 or less. Thereby, the above-described effect are more significantly exhibited. That is, the molar ratio (C₂/C₁) of the content C₂ of the scavenger with respect to the content C₁ of the cation may be, for example, 0.1 to 5, 0.1 to 3, 0.1 to 2, 0.3 to 5, 0.3 to 3, 0.3 to 2, 0.5 to 5, 0.5 to 3, or 0.5 to 2.

The reducing agent is not particularly limited as long as it is a substance capable of reducing a trivalent iron ion. Examples of the reducing agent include at least one selected from the group consisting of ascorbic acid, an ascorbic acid salt (for example, sodium ascorbate or the like), a reducing sugar (for example, glucose, fructose, glyceraldehyde, or the like), oxalic acid, an oxalic acid salt (for example, sodium oxalate or the like), formic acid, an alkali metal iodide (for example, potassium iodide or the like), and tin (II) chloride.

A molar ratio (C₄/C₃) of a content C₄ of the reducing agent with respect to a content C₃ of the anion may be, for example, 0.1 or more, and is preferably 0.2 or more and more preferably 0.5 or more. Furthermore, the molar ratio (C₄/C₃) of the content C₄ of the reducing agent with respect to the content C₃ of the anion may be, for example, 30 or less, and is preferably 20 or less and more preferably 10 or less. Thereby, the above-described effect are more significantly exhibited. That is, the molar ratio (C₄/C₃) of the content C₄ of the reducing agent with respect to the content C₃ of the anion may be, for example, 0.1 to 30, 0.1 to 20, 0.1 to 10, 0.2 to 30, 0.2 to 20, 0.2 to 10, 0.5 to 30, 0.5 to 20, or 0.5 to 10.

The dopant of the present embodiment may contain, as necessary, a substance other than the anion, the cation, the scavenger, and the reducing agent which are described above. Such a substance is not particularly limited as long as it does not inhibit an action of the dopant, and examples thereof include water, an organic solvent, and the like.

The dopant of the present embodiment may include a plurality of kinds of the anion, the cation, the scavenger, and the reducing agent, respectively.

By doping a p-type material for thermoelectric conversion with the dopant of the present embodiment, an n-type material for thermoelectric conversion is obtained. The amount of the dopant doped in the p-type material for thermoelectric conversion is not particularly limited, and may be, for example, an amount that satisfies the preferred range of the amount of the anion (complex ion) doped in the p-type material for thermoelectric conversion described below.

The amount of the anion (complex ion) doped in the p-type material for thermoelectric conversion may be, for example, 0.1 parts by mass or more, and is preferably 1.0 part by mass or more and more preferably 10 parts by mass or more, with respect to 100 parts by mass of the carbon nanotube in the p-type material for thermoelectric conversion. Furthermore, the amount of the anion (complex ion) doped in the p-type material for thermoelectric conversion may be, for example, 300 parts by mass or less, and is preferably 200 parts by mass or less and more preferably 150 parts by mass or less, with respect to 100 parts by mass of the carbon nanotube in the p-type material for thermoelectric conversion. That is, the amount of the anion (complex ion) doped in the p-type material for thermoelectric conversion may be, for example, 0.1 to 300, 1.0 to 300, 10 to 300, 0.1 to 200, 1.0 to 200, 10 to 200, 0.1 to 150, 1.0 to 150, or 10 to 150, with respect to 100 parts by mass of the carbon nanotube in the p-type material for thermoelectric conversion.

A method for producing an n-type material for thermoelectric conversion of the present embodiment is not particularly limited, and the thermoelectric conversion material can be produced, for example, by the following method.

### <Method for producing n-type material for thermoelectric conversion>

A production method of the present embodiment includes a step of doping a p-type material for thermoelectric conversion with a dopant, the p-type material for thermoelectric conversion containing a carbon nanotube and a conductive resin. The above-described step is also referred to as an n-type conversion step.

The method of doping a p-type material for thermoelectric conversion with a dopant in the n-type conversion step is not particularly limited, and examples thereof include a method of bringing a dopant solution containing a dopant into contact with a p-type material for thermoelectric conversion.

In a preferred embodiment, the n-type conversion step may include an impregnation step of impregnating at least a part of the p-type material for thermoelectric conversion with a dopant solution containing the dopant and a solvent, and a solvent removal step of removing the solvent from the material obtained after the dopant solution impregnation.

The boiling point of the solvent is preferably 70°C or higher, more preferably 90°C or higher, and further preferably 110°C or higher, and may be 150°C or higher. In the case of performing a heating treatment in the solvent removal step described below, when the boiling point of the solvent is high, it is difficult to remove the solvent at the time of the heating treatment, and the effect of the heating treatment is more efficiently exhibited. That is, when a solvent having the above-described preferable boiling point range is used, the effect of the heating treatment is more significantly exhibited.

Examples of the solvent include water, acetonitrile, ethanol, ethylene glycol, dimethyl sulfoxide (DMSO), N-methylpyrrolidone, N,N-dimethylformamide, N,N-dimethylacetamide, and the like. Note that, the solvent may be used alone or as a mixture of two or more kinds thereof.

The dopant solution of the present embodiment may include other components to the extent that the effects of the present invention are not impaired, in addition to the dopant and the solvent. Examples of the other components include a binder resin, an antioxidant, a thickener, a surfactant, and the like.

The method of impregnating the p-type material for thermoelectric conversion with a dopant solution is not particularly limited, and examples thereof include methods such as immersing the p-type material for thermoelectric conversion into a dopant solution and applying a dopant solution to the p-type material for thermoelectric conversion.

The dopant of the present embodiment is excellent in doping efficiency, and thus doping can be completed in a short time. The time for impregnating the p-type material for thermoelectric conversion with a dopant solution may be, for example, 10 minutes to 72 hours, and may be 30 minutes to 24 hours. When the time for impregnation of the dopant solution is within the above range, the productivity of the n-type material for thermoelectric conversion is excellent.

Herein, in the present embodiment, the conductive resin is contained in the p-type material for thermoelectric conversion, but in the case of using such a p-type material for thermoelectric conversion, there is a concern that the conductive resin prevents the dopant from being in contact with the carbon nanotube. Furthermore, in a conventional dopant, there is a case where it is necessary to require time and effort such as a long-time doping process of the p-type material for thermoelectric conversion and shear dispersion of the p-type material for thermoelectric conversion in a dopant treatment solution. The dopant of the present embodiment resolves such time and effort and can provide an n-type material having excellent thermoelectric conversion performance for a short impregnating time of about 10 minutes.

In the impregnation step, a material impregnated with the dopant solution is obtained, and this material is provided to the solvent removal step. Note that, the solvents used in the impregnation step other than those which are impregnated in or adhere to the material may be removed at the final stage of the impregnation step. For example, in a case where the p-type material for thermoelectric conversion is immersed into a dopant solution in the impregnation step, the material may be taken out from the dopant solution and then provided to the solvent removal step.

In the solvent removal step, at least a part of the solvent is removed from the material obtained after the above-described dopant solution impregnation. In the solvent removal step, it is not necessary to remove the whole solvent, and the solvent may remain to the extent that the material sufficiently functions as an n-type material for thermoelectric conversion.

The solvent removal step may be, for example, a step of removing the solvent by natural drying, and may be a step of removing the solvent by performing a heating treatment, a decompression treatment, or the like.

In a preferred embodiment, the solvent removal step may include a step of subjecting the thermoelectric conversion material impregnated with the solvent to a heating treatment. In the present embodiment, it is conceivable that voids between the carbon nanotubes are filled so as to form a denser structure by the solvent, which has improved compatibility with the conductive resin by heating, causing the conductive resin in the material to flow. Therefore, in the present embodiment, there is a tendency that thermoelectric conversion properties are more significantly improved.

In the present embodiment, the temperature of the heating treatment is not particularly limited, and may be, for example, 40°C or higher, and is preferably 50°C or higher and more preferably 60°C or higher. By increasing the temperature of the heating treatment, there is a tendency that the Seebeck coefficient of the thermoelectric conversion material is improved. Furthermore, the temperature of the heating treatment may be, for example, 250°C or lower, and is preferably 225°C or lower and more preferably 200°C or lower. By decreasing the temperature of the heating treatment, there is a tendency that the electric conductivity of the thermoelectric conversion material is improved. In the present embodiment, there is a tendency that the Seebeck coefficient and the electric conductivity vary depending on the temperature of the heating treatment. Therefore, the temperature of the heating treatment may be appropriately selected, for example, within the above-described range in view of a balance between numerical values of the Seebeck coefficient and the electric conductivity.

In the present embodiment, the time for the heating treatment is not particularly limited. The time for the heating treatment may be, for example, 1 minute or longer and is preferably 10 minutes or longer, and may be 12 hours or shorter and is preferably 6 hours or shorter.

Note that, the heating treatment in the present embodiment is not necessarily performed for removing the solvent, and the solvent removal step according to the present embodiment may be a step of further performing a treatment of removing the solvent after the heating treatment.

In the present embodiment, a part doped with the dopant of the p-type material for thermoelectric conversion becomes an n-type material for thermoelectric conversion. In the present embodiment, the entire p-type material for thermoelectric conversion may be doped with the dopant to obtain an n-type material for thermoelectric conversion, and a part of the p-type material for thermoelectric conversion may be doped with the dopant to obtain a composite body of the p-type material for thermoelectric conversion and an n-type material for thermoelectric conversion.

In a preferred embodiment, the impregnation step may be a step of impregnating a part of a resin layer containing the p-type material for thermoelectric conversion with a dopant solution containing the dopant and a solvent, and the solvent removal step may be a step of removing the solvent from the resin layer obtained after the dopant solution impregnation to obtain a thermoelectric conversion layer containing the p-type material for thermoelectric conversion and an n-type material for thermoelectric conversion. According to such an embodiment, a thermoelectric conversion layer containing a p-type material and an n-type material can be easily obtained. Furthermore, in such an embodiment, the range of the impregnation of the dopant solution in the impregnation step is appropriately set so that a thermoelectric conversion layer having a desired pin configuration can be easily obtained.

The shape of the n-type material for thermoelectric conversion is not particularly limited. For example, the n-type material for thermoelectric conversion may be obtained as a film supported by a support by subjecting a composite material in which the film of the p-type material for thermoelectric conversion is formed on a support to a doping process.

Examples of the support include polyimide, polyethylene terephthalate, polyethylene naphthalate, polyethylene isophthalate, polybutylene telephthalate, polycarbonate, polyether ether ketone, polyphenylsulfide, polysulfone, glass, copper, silver, gold, aluminum, and the like. Among these, from the viewpoint that the obtained thermoelectric conversion material exhibits favorable plasticity, the support is preferably selected from the group consisting of polyimide, polyethylene terephthalate, and polyethylene naphthalate.

The film thickness of the n-type material for thermoelectric conversion is preferably 100 nm to 1 mm, more preferably 200 nm to 800 µm, and further preferably 300 nm to 600 µm, from the viewpoint of obtaining appropriate electric resistance and excellent flexibility.

The n-type material for thermoelectric conversion of the present embodiment can be suitably used as an n-type material for a thermoelectric conversion element. Furthermore, the n-type material for thermoelectric conversion of the present embodiment can also be suitably used for use applications such as a Peltier element and a temperature sensor.

### <Thermoelectric conversion element>

A thermoelectric conversion element of the present embodiment contains the above-described n-type material for thermoelectric conversion. The thermoelectric conversion element of the present embodiment may further contain the above-described p-type material for thermoelectric conversion.

The thermoelectric conversion element of the present embodiment may include, for example, two conductive substrates and a thermoelectric conversion layer disposed between the conductive substrates and containing the above-described n-type material for thermoelectric conversion. Furthermore, the thermoelectric conversion layer may further contain the above-described p-type material for thermoelectric conversion.

The two conductive substrates can also be called a first electrode and a second electrode, respectively.

The thermoelectric conversion element of the present embodiment may be produced, for example, by a production method including a lamination step of disposing a thermoelectric conversion layer containing the n-type material for thermoelectric conversion and the p-type material for thermoelectric conversion on a conductive substrate.

The thermoelectric conversion element of the present embodiment may be produced, for example, by a production method including a first lamination step of disposing a resin layer containing a p-type material for thermoelectric conversion on one conductive substrate, an impregnation step of impregnating a part of the resin layer with a dopant solution containing the above-described dopant and a solvent, a solvent removal step of removing the solvent to obtain a thermoelectric conversion layer containing the p-type material for thermoelectric conversion and an n-type material for thermoelectric conversion, and a second lamination step of laminating the other conductive substrate on the thermoelectric conversion layer.

The thermoelectric conversion element may further include configuration other than the above. For example, the thermoelectric conversion element may further include a sealing material for sealing the thermoelectric conversion layer, a wiring for electrically connecting thermoelectric conversion elements to each other or for taking out electric power to an external circuit, a heat insulation material or thermal conductive material for controlling the thermal conductivity of the thermoelectric conversion element, and the like.

Hereinbefore, preferred embodiments of the present invention have been described, but the present invention is not intended to be limited to the above-described embodiment.

### Examples

Hereinafter, the present invention will be more specifically described by means of Examples; however, the present invention is not limited to these Examples. Hereinafter, preparation was performed at 23°C unless otherwise specified.

### (Example 1)

### <Preparation of liquid mixture>

0.28 g of "Clevious PH1000" (PEDOT/PSS aqueous dispersion, solid content concentration: 1.2% by mass) manufactured by Heraeus Holding and 5 g of "EC-DH" (single-layer carbon nanotube aqueous dispersion, single-layer CNT concentration: 0.2% by mass, diameter of the single-layer CNT: 0.9 to 1.7 nm, G/D ratio: 41) manufactured by MEIJO NANO CARBON Co., Ltd. were stirred and mixed with a planetary centrifugal mixer ("THINKY MIXER ARE-310" manufactured by THINKY CORPORATION) to prepare a liquid mixture in which the content of the single-layer CNT is 75% by mass with respect to the total amount of PEDOT/PSS and the single-layer CNT. Note that, the term "PEDOT/PSS" refers to a conductive polymer composed of PEDOT and PSS.

### <Production of composite film>

The liquid mixture was dropped onto a polyimide film (thickness: 100 µm) washed with acetone, and the liquid mixture was applied to the film using a doctor blade with a gap of 2.5 mm, placed in a blow drying machine set at 60°C, and dried for 2 hours. Thereby, a composite film having a film thickness of 25 µm was formed on the polyimide film. For the measurement of the film thickness, a high-precision digital micrometer (manufactured by Mitutoyo Corporation, MDH-25MB) was used, the film thickness of a place where the composite film was formed and the film thickness of a place where only the polyimide film was present were respectively measured, and a difference therebetween was calculated as the film thickness of the composite film.

### <Solvent treatment and solvent removal>

The composite film was subjected to an immersion treatment in dimethyl sulfoxide (DMSO, boiling point: 189°C) at room temperature for 5 minutes. Thereafter, the composite film was disposed on a hot plate set at 60°C for 120 minutes. Thereby, a layer (thickness: 5 µm) of the p-type material for thermoelectric conversion was produced. The Seebeck coefficient (referred to as "Seebeck coefficient before the doping process" in the following tables) of the obtained p-type thermoelectric conversion material was 22.8 µV/K.

### <Production of n-type material for thermoelectric conversion>

0.063 g of potassium ferrocyanide trihydrate, 0.188 g of benzo-18-crown-6-ether, and 0.018 g of L-ascorbic acid were dissolved in 5 mL of ultrapure water (the molar concentration of potassium ferrocyanide: 0.03 M, the molar concentration of benzo-18-crown-6-ether: 0.12 M, the molar concentration of L-ascorbic acid: 0.02 M), thereby obtaining a dopant solution. The above-described p-type material for thermoelectric conversion was cut into 10 mm × 10 mm together with the polyimide film, and 40 µL of the dopant solution was dropped thereonto. Thereafter, the resultant was dried at 60°C for 30 minutes, then placed in a blow drying machine set at 100°C, and subjected to a heating treatment for 60 minutes. Thereby, an n-type material for thermoelectric conversion was obtained. The Seebeck coefficient (referred to as "Seebeck coefficient after the doping process" in the following tables) of the obtained n-type material for thermoelectric conversion was -20.9 µV/K. Note that, the potassium ferrocyanide trihydrate contains a divalent iron ion.

Note that, the Seebeck coefficients of the p-type material for thermoelectric conversion and the n-type material for thermoelectric conversion were measured by the following method.

The thermoelectric conversion material (the p-type material for thermoelectric conversion or the n-type material for thermoelectric conversion) disposed on the polyimide film was cut into 20 mm × 10 mm, thereby preparing a test piece. One end of the longer side of the test piece was cooled (the initial temperature of the test piece - 5°C = 18°C), the other end of the longer side of the test piece was heated (the initial temperature of the test piece + 5°C = 28°C), the temperature difference and voltage generated at both ends were measured with an alumel-chromel thermocouple, and the Seebeck coefficient was calculated from the inclination of the temperature difference and the voltage.

### (Example 2)

An n-type material for thermoelectric conversion was obtained in the same manner as in Example 1, except that 0.018 g of D-(+)-glucose was used instead of L-ascorbic acid. Note that, the molar concentration of D-(+)-glucose in the dopant solution was 0.02 M. In Example 2, the Seebeck coefficient of the p-type material for thermoelectric conversion before the doping process was 23.3 µV/K, and the Seebeck coefficient of the n-type material for thermoelectric conversion after the doping process was -19.2 µV/K.

### (Example 3)

An n-type material for thermoelectric conversion was obtained in the same manner as in Example 1, except that a solution obtained by dissolving 0.021 g of potassium ferrocyanide trihydrate, 0.063 g of benzo-18-crown-6-ether, and 0.035 g of D-(+)-glucose in 5 mL of ultrapure water was used as a dopant solution. Note that, in the dopant solution, the molar concentration of potassium ferrocyanide was 0.01 M, the molar concentration of benzo-18-crown-6-ether was 0.04 M, and the molar concentration of D-(+)-glucose was 0.04 M. In Example 3, the Seebeck coefficient of the p-type material for thermoelectric conversion before the doping process was 22.5 µV/K, and the Seebeck coefficient of the n-type material for thermoelectric conversion after the doping process was -16.4 µV/K.

### (Example 4)

An n-type material for thermoelectric conversion was obtained in the same manner as in Example 1, except that 0.009 g of oxalic acid was used instead of L-ascorbic acid. Note that, the molar concentration of oxalic acid in the dopant solution was 0.02 M. In Example 4, the Seebeck coefficient of the p-type material for thermoelectric conversion before the doping process was 21.4 µV/K, and the Seebeck coefficient of the n-type material for thermoelectric conversion after the doping process was -21.5 µV/K.

### (Comparative Example 1)

An n-type material for thermoelectric conversion was obtained in the same manner as in Example 1, except that L-ascorbic acid was not used. In Comparative Example 1, the Seebeck coefficient of the p-type material for thermoelectric conversion before the doping process was 23.1 µV/K, and the Seebeck coefficient of the n-type material for thermoelectric conversion after the doping process was -15.3 µV/K.

### (Comparative Example 2)

An n-type material for thermoelectric conversion was obtained in the same manner as in Example 3, except that D-(+)-glucose was not used. In Comparative Example 2, the Seebeck coefficient of the p-type material for thermoelectric conversion before the doping process was 23.4 µV/K, and the Seebeck coefficient of the n-type material for thermoelectric conversion after the doping process was -7.8 µV/K.

### (Comparative Example 3)

A p-type thermoelectric conversion material was doped with a dopant in the same manner as in Example 1, except that potassium ferrocyanide trihydrate was not used. In Comparative Example 3, the Seebeck coefficient before the doping process was 25.66 µV/K, and the Seebeck coefficient after the doping process was 25.54 µV/K.

The results of Examples 1 to 4 and Comparative Examples 1 to 3 are shown in Table 1 and Table 2. Note that, in the table, the concentration of the complex ion, the concentration of the cation scavenger, and the concentration of the reducing agent indicate the concentrations of the respective components in a doping solution. Furthermore, in the table, "Reducing agent 1" represents L-ascorbic acid, "Reducing agent 2" represents D-(+)-glucose, and "Reducing agent 3" represents oxalic acid.

**[Table 1]**

| | Example 1 | Example 2 | Example 3 | Example 4 |
|---|---|---|---|---|
| Concentration (mol/L) of complex ion | 0.030 | 0.030 | 0.010 | 0.030 |
| Concentration (mol/L) of cation scavenger | 0.120 | 0.120 | 0.040 | 0.120 |
| Type of reducing agent | Reducing agent 1 | Reducing agent 2 | Reducing agent 2 | Reducing agent 3 |
| Concentration (mol/L) of reducing agent | 0.020 | 0.020 | 0.040 | 0.020 |
| Seebeck coefficient (µV/K) before doping process | 22.8 | 23.3 | 22.5 | 21.4 |
| Seebeck coefficient (µV/K) after doping process | -20.9 | -19.2 | -16.4 | -21.5 |

**[Table 2]**

| | Comparative Example 1 | Comparative Example 2 | Comparative Example 3 |
|---|---|---|---|
| Concentration (mol/L) of complex ion | 0.030 | 0.010 | 0 |
| Concentration (mol/L) of cation scavenger | 0.120 | 0.040 | 0.12 |
| Type of reducing agent | - | - | - |
| Concentration (mol/L) of reducing agent | - | - | - |
| Seebeck coefficient (µV/K) before doping process | 23.1 | 23.4 | 25.66 |
| Seebeck coefficient (µV/K) after doping process | -15.3 | -7.8 | 25.54 |

As shown in Table 1, in Examples 1 to 4, the n-type conversion proceeded efficiently with small amounts of the complex ion and cation scavenger, and an n-type material having a large absolute value of the Seebeck coefficient was obtained. On the other hand, in Comparative Examples 1 and 2, the absolute value of the Seebeck coefficient of the obtained n-type material was smaller than those of Examples 1 and 3. Furthermore, in Comparative Example 3, an n-type material could not be obtained.

### (Example 5)

### <Production of p-type material for thermoelectric conversion>

A p-type material for thermoelectric conversion was produced by the same method as in Example 1. The Seebeck coefficient (referred to as "Seebeck coefficient before the doping process" in the following tables) of the obtained p-type thermoelectric conversion material was 22.5 µV/K.

### <Production of n-type material for thermoelectric conversion>

A dopant solution was prepared in the same manner as in Example 1, except that in the dopant solution, the molar concentration of potassium ferrocyanide was changed to 0.05 M, the molar concentration of benzo-18-crown-6-ether was changed to 0.2 M, and the molar concentration of L-ascorbic acid was changed to 0.05 M. An n-type material for thermoelectric conversion was produced in the same manner as in Example 1, except that the p-type material for thermoelectric conversion and the dopant solution thus obtained were used. The Seebeck coefficient (referred to as "Seebeck coefficient after the doping process" in the following tables) of the obtained n-type material for thermoelectric conversion was -19.4 µV/K.

### (Example 6)

An n-type material for thermoelectric conversion was obtained in the same manner as in Example 5, except that the molar concentration of L-ascorbic acid in the dopant solution was changed to 0.12 M. In Example 6, the Seebeck coefficient of the p-type material for thermoelectric conversion before the doping process was 24.4 µV/K, and the Seebeck coefficient of the n-type material for thermoelectric conversion after the doping process was -21.0 µV/K.

### (Example 7)

An n-type material for thermoelectric conversion was obtained in the same manner as in Example 5, except that the molar concentration of L-ascorbic acid in the dopant solution was changed to 0.23 M. In Example 6, the Seebeck coefficient of the p-type material for thermoelectric conversion before the doping process was 23.8 µV/K, and the Seebeck coefficient of the n-type material for thermoelectric conversion after the doping process was -20.6 µV/K.

### (Comparative Example 4)

An n-type material for thermoelectric conversion was obtained in the same manner as in Example 5, except that L-ascorbic acid was not added to the dopant solution. In Comparative Example 4, the Seebeck coefficient of the p-type material for thermoelectric conversion before the doping process was 21.78 µV/K, and the Seebeck coefficient of the n-type material for thermoelectric conversion after the doping process was -23.0 µV/K.

The results of Examples 5 to 7 and Comparative Example 4 are shown in Table 3. Note that, in the table, the concentration of the complex ion, the concentration of the cation scavenger, and the concentration of the reducing agent indicate the concentrations of the respective components in a doping solution. Furthermore, in the table, "Reducing agent 1" represents L-ascorbic acid.

### (Durability test under high-temperature and high-humidity conditions)

The n-type material for thermoelectric conversion obtained in each of Examples 5 to 7 and Comparative Example 4 was left to stand still in an environment of 85°C and a humidity of 85%, and was taken out after a predetermined time (500 hours, 1000 hours, 2000 hours, and 3000 hours), and the Seebeck coefficient was measured. The measurement results at each time are shown in Table 3.

**[Table 3]**

| | | Example 5 | Example 6 | Example 7 | Comparativ e Example 4 |
|---|---|---|---|---|---|
| Concentration (mol/L) of complex ion | | 0.05 | 0.05 | 0.05 | 0.05 |
| Concentration (mol/L) of cation scavenger | | 0.2 | 0.2 | 0.2 | 0.2 |
| Type of reducing agent | | Reducing agent 1 | Reducing agent 1 | Reducing agent 1 | - |
| Concentration (mol/L) of reducing agent | | 0.05 | 0.12 | 0.23 | - |
| Seebeck coefficient (µV/K) before doping process | | 22.5 | 24.4 | 23.8 | 21.78 |
| Seebeck coefficient (µV/K) after doping process | | -19.4 | -21.0 | -20.6 | -23.0 |
| Seebeck coefficient (µV/K) after durability test | 500 h | -23.8 | -22.7 | -25.5 | -20.6 |
| | 1000 h | -24.2 | -24.4 | -23.0 | 6.9 |
| | 2000 h | -23.3 | -23.0 | -23.2 | 18.4 |
| | 3000 h | -23.7 | -23.7 | -23.9 | 25.5 |

As shown in Table 3, in Examples 5 to 7, the n-type conversion proceeded efficiently, and an n-type material having a large absolute value of the Seebeck coefficient was obtained. Furthermore, in Examples 5 to 7, it was confirmed that the Seebeck coefficient was maintained to a value close to the initial value even under high-temperature and high-humidity conditions, and durability was excellent under high-temperature and high-humidity conditions. On the other hand, in Comparative Example 4, although the n-type conversion proceeded by the doping of the complex ion and the cation scavenger, the value of the Seebeck coefficient considerably varied under high-temperature and high-humidity conditions, and after 1000 hours, the Seebeck coefficient became a positive value, so that it became difficult to use a material as the n-type material.

## Claims

1. An n-type material for thermoelectric conversion obtained by doping a p-type material for thermoelectric conversion with a dopant, the p-type material for thermoelectric conversion containing a carbon nanotube and a conductive resin, wherein
the dopant contains a complex ion containing a divalent iron ion, an alkali metal cation, a cation scavenger, and a reducing agent.

2. The n-type material for thermoelectric conversion according to claim 1, wherein the cation scavenger is a crown ether-based compound.

3. The n-type material for thermoelectric conversion according to claim 2, wherein the cation scavenger is a crown ether-based compound having a benzene ring in the molecule.

4. The n-type material for thermoelectric conversion according to claim 1, wherein the conductive resin is configured by poly(3,4-ethylenedioxythiophene) and an electron acceptor.

5. The n-type material for thermoelectric conversion according to claim 1, wherein the reducing agent includes at least one selected from the group consisting of ascorbic acid and a salt thereof, a reducing sugar, oxalic acid and a salt thereof, formic acid, an alkali metal iodide, and tin (II) chloride.

6. A dopant doped in a p-type material for thermoelectric conversion and used for n-type conversion of the p-type material for thermoelectric conversion, the p-type material for thermoelectric conversion containing a carbon nanotube and a conductive resin, the dopant comprising:
an anion that is a complex ion; an alkali metal cation; a cation scavenger; and a reducing agent.

7. A method for producing an n-type material for thermoelectric conversion, the method comprising a step of doping a p-type material for thermoelectric conversion with a dopant, the p-type material for thermoelectric conversion containing a carbon nanotube and a conductive resin, wherein
the dopant contains an anion that is a complex ion, an alkali metal cation, a cation scavenger, and a reducing agent.

8. The method for producing an n-type material for thermoelectric conversion according to claim 7, wherein the step includes:
an impregnation step of impregnating at least a part of the p-type material for thermoelectric conversion with a dopant solution containing the dopant and a solvent; and
a solvent removal step of removing the solvent.

9. The method for producing an n-type material for thermoelectric conversion according to claim 7, wherein the step includes:
an impregnation step of impregnating a part of a resin layer containing the p-type material for thermoelectric conversion with a dopant solution containing the dopant and a solvent; and
a solvent removal step of removing the solvent to obtain a thermoelectric conversion layer containing the p-type material for thermoelectric conversion and an n-type material for thermoelectric conversion.

10. A thermoelectric conversion element comprising the n-type material for thermoelectric conversion according to any one of claims 1 to 5.

11. The thermoelectric conversion element according to claim 10, further comprising the p-type material for thermoelectric conversion.
